# EUROPEAN PATENT APPLICATION

(11) **EP 3 182 442 A1**
(43) Date of publication of application: **21.06.2017**
(21) Application number: 16202361.8
(22) Date of filing: 06.12.2016
(51) Int. Cl.: H01L 21/56, H01L 23/528, H01L 25/065

(54) **POWER GRID BALANCING OF SEMICONDUCTOR APPARATUS, SYSTEM AND METHOD**

(30) Priority: 16.12.2015 US 201514971601
(71) Applicant: NXP USA, Inc., Austin TX 78735 (US)
(72) Inventor: KOCH, Thomas, 5656 AG Eindhoven (NL); HATIRNAZ, Ilhan, 5656 AG Eindhoven (NL); ROHLEDER, Michael, 5656 AG Eindhoven (NL)
(74) Representative: Pomper, Till

(57) **Abstract**

A semiconductor apparatus for power distribution on a die, the semiconductor apparatus, comprising a first die, wherein the first die comprises a first integrated circuit, a dam coupled to the first die, wherein the dam is a metal ring, a second die, wherein the second die comprises a second integrated circuit, wherein the first and second dies are stacked together and are electrically connected, and a pair of metal connectors coupled to the dam and an edge of the first die, wherein power and ground wires are coupled to the dam, wherein the power transmitted through the power and ground wires is distributed through the dam and metal connectors to the first die and wherein the power transmitted to the first die is distributed to the to the second die.

## Description

### FIELD OF THE INVENTION

The invention relates to a power grid balancing, and more particularly, to utilizing the packaging dam for power grid balancing.

### BACKGROUND

A System in Package ("SiP") is a semiconductor device in which one or more integrated circuits ("ICs" or "die"), typically of different functionalities, which otherwise would have been realized using a number of individual chips, are combined into a complete electronic system in a single package. These functions may be implemented through digital or analog components and may include passive components. They are implemented within a single chip which performs as a system or a sub-system with an equivalent interface as in individually-packaged ICs. A SiP may contain multiple dies which within a SiP may be stacked vertically on a substrate either face-to-face or bottom-to-face. The dies may contain power supply wires that are bonded to the package to receive the required power from outside the SiP.

Combining multiple ICs into a single package raises several issues. One of these issues is the efficient delivery of sufficient power into all the dies within the SiP. Dependent on the physical structure of the SiP, the availability of a sufficient amount of pads for power supply for every die and the connections to these pads may become a challenge. In many prior art systems, combining the dies face-to-face makes it a challenge to provide enough power delivery resources to the dies, especially to the one which does not have accessible pads on it and has its data and power signals routed over the other die to the external world. In such cases, significantly more wiring resources may be allocated for routing the necessary signals, especially for the power supplies due to their high count. In other prior art systems, combining the dies back-to-face requires through-silicon-via (TSV) connections, which are expensive and require more area on the die. As die area is a precious commodity, methods balancing the power and reducing the additional area required for power delivery wiring are desired.

The connections between the vertically-stacked dies within a SiP may be established using copper pillars. Copper is a popular material for integrated circuits, especially between the dies, due to its excellent thermal and electrical properties. Copper pillar interconnections are more reliable and less resistive and therefore their usage result in better performance in terms of timing and area.

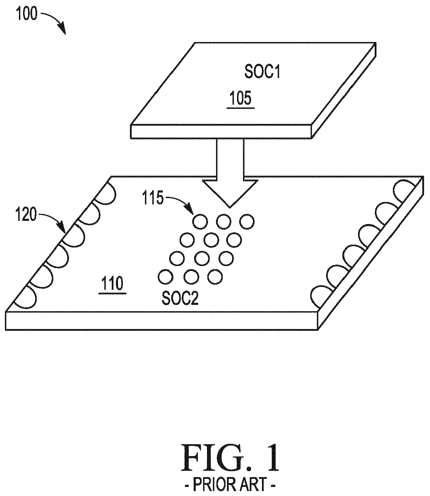

A prior art SiP with multiple semiconductor ICs organized face-to-face is shown in Figure 1. The SiP 100 includes a first die 105 labeled SoC1 and a second die 110 labeled SoC2. The first die 105 and second die 110 are positioned face-to-face, having their sides with no-passivation (faces) connected. The area of the face of the first die 105 is smaller than the area of the face of the second die 110. In this prior art system, the face of the first die 105 would be completely positioned on the face of the second die 110; inhibiting any connection at the face of the first die 105. The first die 105 and second die 110 are electrically connected through copper pillars 115 on one die and receiving cavities (not shown) on the other die. The base of the receiving cavity includes a conductive metal, including but not limited to copper. The second die 110 may include copper pillars 115, or the receiving cavities, and pads 120. The first die 105 may include copper pillars or the receiving cavities (not shown) which are in connection with the copper pillars of the second die 110 and pads that may be used for test purposes of the singular die only, because they are not accessible within a SiP. Copper pillar connections require copper pillars on one die and the receiving cavity on the other die. In this prior art system, power supply bonding wires (not shown) may be connected from the package to the pads 120, some or all of which may then be connected to the copper pillars 115 to provide power from the second die 110 to the first die 105. The wiring from the pads 120 of the second die 110 to the copper pillars 115 of the second die 110 to the copper pillars of the first die 105 may result in a considerable voltage drop due to the resistivity of the wires, and may cause differences in the supply voltage seen by different regions of the second die 110 and of the first die 105. In addition, the distribution of the power demand on the first die 105 may be non-uniform, which would cause a sub-set of the pads 120 and the copper pillars 115 of the second die 110 to encounter higher current than others.

More recent technologies have very stringent rules on the permitted voltage drop in the supply grid. Accordingly, any additional impact by the power supply wiring may therefore result in severe issues, such as lower performance, higher power consumption and reliability issues. Voltage drop may be increased further by unbalanced power supply wiring or pad availability due to physical limitations and a non-uniform distribution of power consumption on the die to be supplied.

When combining multiple semiconductor integrated circuits in a SiP, sufficient and balanced power delivery needs to be ensured. The necessity of supplying one die over the second die may increase the level of unbalance in the power distribution network, which may negatively impact the voltage drop requirements for the supplied devices, since there is already some inherent voltage drop in the supply network. Therefore, an improved method and system for connecting the power connections on the larger die and for providing a mechanism to balance all the power supply over the multiple power supply wires is desired.

### BRIEF DESCRIPTION OF THE DRAWINGS

A more complete appreciation of the invention is provided by reference to the following detailed description of the appended drawings and figures. The following descriptions, in conjunction with the appended figures, enable a person having skill in the art to recognize the numerous advantages and features of the invention by understanding the various embodiments. These drawings are provided to facilitate the reader's understanding of the invention and shall not be considered limiting of the breadth, scope, or applicability of the invention. It should be noted that for clarity and ease of illustration these drawings are not necessarily made to scale. The following figures are utilized to best illustrate these features.

Some of the figures included herein illustrate various embodiments of the invention from different viewing angles. Although the accompanying descriptive text may refer to such views as "top," "bottom" or "side" views, such references are merely descriptive and do not imply or require that the invention be implemented or used in a particular spatial orientation unless explicitly stated otherwise.
FIG. 1 is a diagram of a system-in-package (SiP) containing multiple dies according to the prior art.
FIG. 2 is a diagram of a die according to one embodiment of the invention.
FIG. 3 is a cross-section view of a system in package according to one embodiment of the invention.
FIG. 4 is a diagram of the multiple die SiP according to one embodiment of the invention.
FIG. 5 is an image of a multiple die SiP according to the prior art.
FIG. 6 is an image of a multiple die SiP according to one embodiment of the invention.
FIG. 7 is a flow diagram depicting a method according to one embodiment of the invention.

The figures are not intended to be exhaustive or to limit the invention to the precise form disclosed. It should be understood that the invention can be practiced with modification and alteration, and that the invention be limited only by the claims and the equivalents thereof.

### DETAILED DESCRIPTION OF THE INVENTION

A multiple die system-in-a-package is disclosed. Any of the multiple dies may be a semiconductor integrated circuit. Power and ground to the top die are supplied over the bottom die. In one embodiment, the power distribution for the bottom die is balanced through the implementation of the power and ground supply through the dam rings. The power distribution for the top die is received from the bottom die through the copper pillars and receiving cavities. The power and the ground connections of the bottom die are coupled to a dam formed from metal and surrounding the second die like a ring. The top and bottom dies are stacked together and may be permanently mounted together. The power and ground wires are coupled to the dam, wherein the power transmitted through the power and ground wires is distributed through the dam and metal connectors to the top die. The dam spreads the power distribution throughout each side of the top die, reducing resistance of the supply network and hence voltage drops and power surges.

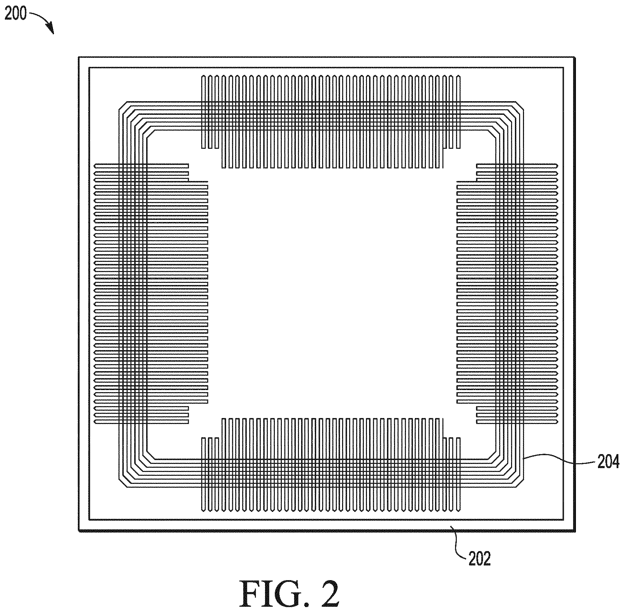

Referring now to Figure 2, a diagram of a die according to an embodiment of the invention is disclosed. A die 200 is shown. A dam 204 is located on top of the die 200. The dam 204 is made up of at least one ring and may include several rings. The dam 204 is formed during the packaging process. The dam 204 protects the wire-bonding pads during the resist dispense of the packaging process. The dam 204 rings may be formed from a variety of materials, including but not limited to, low resistivity materials and metals. The dam 204 not only protects the components during packaging, the dam 204, according to one embodiment of the invention, assists in the balancing of the power grid for the die 200 and an associated system in package (SiP), where the die 200 supplies another die (not shown) over the shown power connections 202. In one embodiment, the dam 204 metal rings act as power or ground spreaders for the die 200. Use of the dam 204 for power or ground distribution causes a more robust power and ground mesh. The associated SiP, die 200 and the other die (not shown) are more tolerant against any unbalanced power or ground demand scenarios of static or dynamic nature.

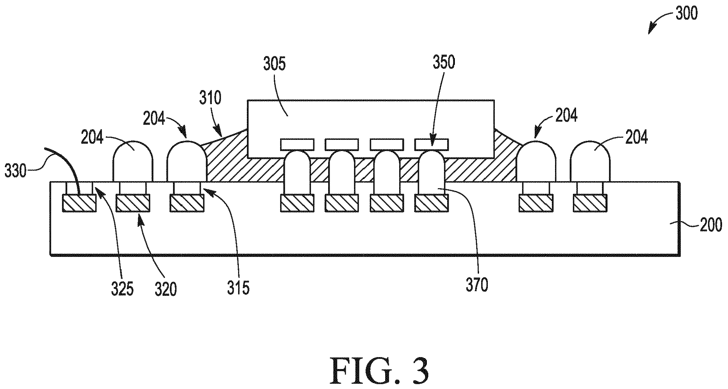

Referring now to Figure 3, a cross section view of a system-in-package according to one embodiment of the invention is disclosed. A system in package (SiP) 300 is shown. The SiP 300 includes the die 200 which contains integrated circuits (not shown) and a second die 305 which contains another set of integrated circuits (not shown). In one disclosed embodiment, the SiP 300 includes multiple dies oriented face-to-face. In another embodiment, the multiple dies are oriented back-to-face. The SiP 300 includes the die 200 which provides a first area of the face of the die 200 and the second die 305 which provides a second area of the face of the second die 305. The area of the face of the die 200 is greater than the area of the face of the second die 305. According to one disclosed embodiment, the face of the second die 305 is positioned on the face of the die 200. The die 200 includes copper pillars 370 which are received in and coupled to the receiving cavities 350 of the second die 305. Power or ground supply is connected via the bond wire 330 through a nitride opening 325 to the metal 320 on die 200. The dam 204 is connected via the contact 315 to metal 320 on die 200. The copper pillar 350 is connected to metal 320. A pad is formed out of the nitride opening 325 and the underlying metal 320 on die 200.

A power supply wire (not shown) is connected to the pads to provide power to the die 200. The pads are coupled to the dam 204, forming a power supply mesh surrounding the second die 305. The dam 204 is then coupled to the second die 305 on any side to provide power and ground to the second die 305. In one embodiment, the dam 204 is coupled to the second die 305 through multiple pairs of power and ground on a single side of the second die 305. In another embodiment, the coupling of the dam 204 through multiple pairs of power and ground are provided on all four sides of the second die 305. Through the use of the dam 204 as a power balancing apparatus, the power supply from the die 200 to the dam 204 to the second die 305 result in reduced voltage drop, and maintains a balanced power supply voltage across the different sides and regions of second die 305. Further, the dam 204 provides a more uniform power consumption for the second die 305.

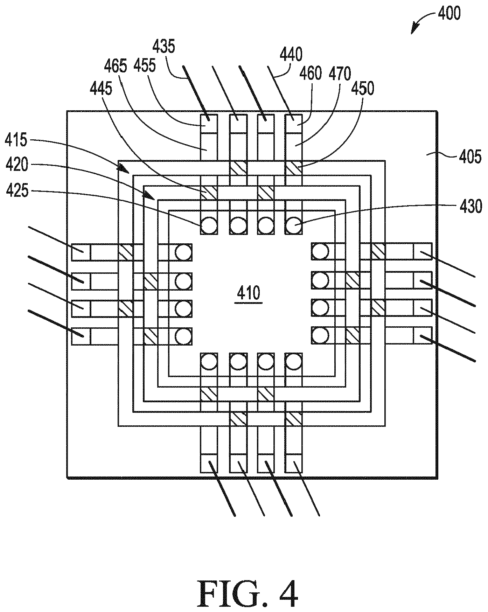

Referring now to Figure 4, a diagram of a SiP consisting of multiple dies according to one embodiment of the invention is disclosed. A SiP 400 contains a bottom die 405 and a top die 410. In one embodiment, the top die 410 is mounted above the bottom die 405 such that the face of the top die 410 is directed toward the face of the bottom die 405. In one embodiment, the top die 410 is permanently mounted to the bottom die 405. In one embodiment, a first dam ring 415 and a second dam ring 420 are located on top of the bottom die 405. The dam rings, 415 and 420, may be continuous and are made of a low-resistive material or metal, including but not limited to copper. The power bond wire 440 is connected to the power pad 460, from which, the power net is routed to the copper pillar 430 using the metal wire 470 in the bottom die 405. Similarly, a ground bond wire 435 is connected to the ground pad 455, from which, the ground net is routed to the copper pillar 425 using the metal wire 465. In one embodiment a single pair of power and ground supply bond wires and pads are provided on a side of the top die 410. In another embodiment, multiple pairs of power and ground supply bond wires and pads are provided on a single side of the top die 410. In another embodiment, at least one pair of power and ground bond wires are provided on more than one side of the top die 410. In another embodiment, multiple pairs of power and ground bond wires are provided on every side of the top die 410. The copper pillars 435 and 425 deliver power and ground, respectively, from the bottom die 405 to the top die 410. In one embodiment there are multiple copper pillars carrying the same power or ground net from the bottom die 405 to the top die 410. There are dam ring connections 450 between the first dam ring 420 and the power supply net 470. Similarly, the ground supply net 465 is coupled to the second dam ring 415 through the connections 445. In this embodiment, there are multiple connections 450 between the dam ring 420 and the power net 470 distributed along the sides of the bottom die 405. In one embodiment, the length of the metal to the first dam ring 415 is equal on all sides of the system in package 400. In one embodiment, the length of the metal to the second dam ring 420 is equal on all sides of the system in package 400.

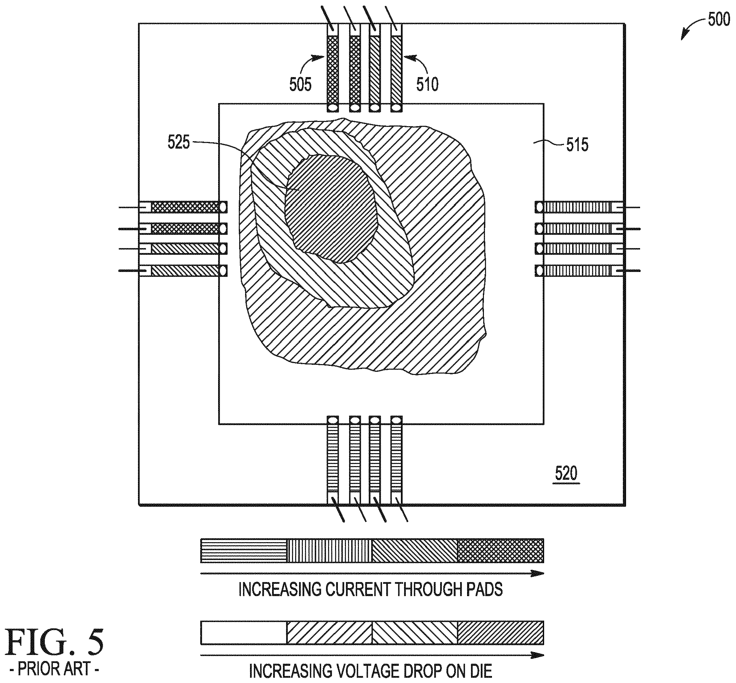

Referring now to Figure 5, an on-die voltage drop image of a multiple die system in a package according to the prior art is disclosed. The prior art system in package 500 is shown. The prior art system in package includes a bottom die 520 and a top die 515. Power line 505 and ground line 510 are coupled to the bottom die 520 and top die 515. The prior art system in package 500 includes two (2) sets of power and ground supply pairs on each side of the top die 515. No dam layer is used to balance the power and ground supplies in SiP. The image of the top die 515 is shaded according to the on-chip voltage drop distribution. The wide rising left-to-right shaded area has the lowest voltage-drop (supply level is highest), whereas the narrow rising left-to-right shaded area 525 is exposed to highest voltage drop due to high activity or supply grid resistivity. In addition, the supply nets, power line 510 and ground line 505 are mapped to different shading according to the current flowing through them. The darker color shading corresponds to higher current flowing through the wire, whereas the brighter colored nets have less current flowing. Due to the resistivity of the power grid and the power demand, certain regions 525 in the die 515 may be exposed to higher voltage drop and the power lines 505 and ground lines 510 in the vicinity of these regions may carry more current into and out of the region.

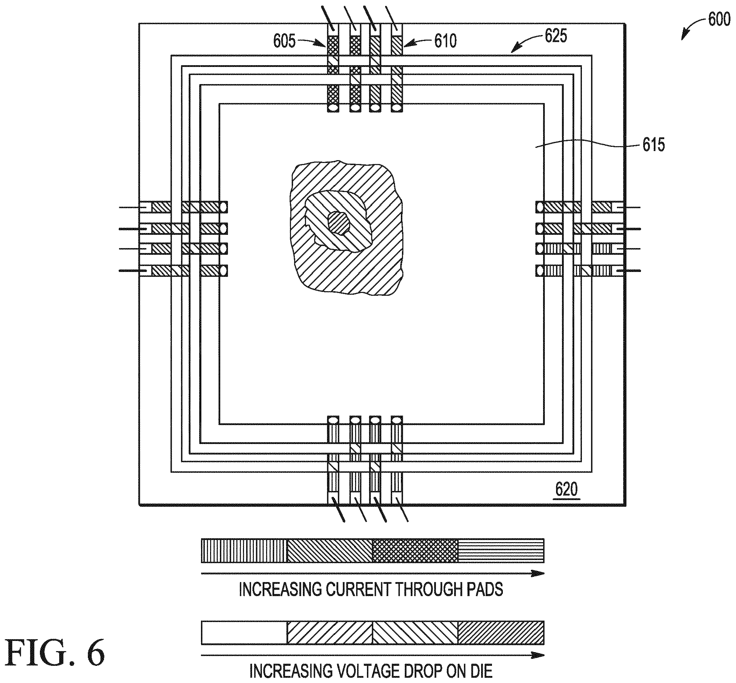

Referring now to Figure 6, an image of a multiple die system in package according to one embodiment of the invention is disclosed. The system in package 600 is shown. The system in package 600 is identical to the prior art system in package 500 except for the inclusion of the dam power supply balancing system according to one embodiment of the invention. The system in package 600 includes a bottom die 620 and a top die 615. Power line 610 and ground line 605 are coupled to the bottom die 620 and are also coupled to the two rings of dam 625. The top die 515 is coupled to the dam 625. The system in package 600 includes two (2) sets of power and ground supply pairs on each side of the top die 615. The image of the top die 615 is shaded according to the on-die voltage drop distribution. The wide rising left-to-right shaded area has the lowest voltage-drop (supply level is highest), whereas the narrow rising left-to-right shaded area is exposed to highest voltage drop due to high activity or supply grid resistivity. The implementation of the dam power supply balancing system according to one embodiment of the invention decreases the resistance of the supply grid significantly, which lowers the amount of current for the pads to provide into the SiP. One or more pads supply higher loads (due to activity in a close-by region) when implemented according to one embodiment of the invention. Consequently, the overall IR-drop is lowered and the current that must be supplied into the top die 615 is better distributed among the supply pads.

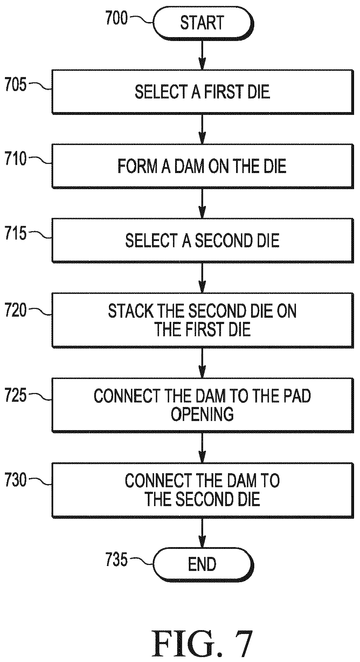

Referring now to Figure 7, a flow diagram depicting a method according to one embodiment of the invention is disclosed. The method begins with Start 700. A first die is selected in step 705. The first die will act as the base of the multiple die semiconductor device. A dam is formed on the first die in step 710. In one embodiment, the dam is a continuous ring on the first die. In another embodiment, the dam is formed by multiple segments on the first die. In one embodiment, the dam is formed from a low resistivity material, including but not limited to metal. A second die is selected in step 715. The second die is selected to be placed upon the first die. The first and second dies are stacked in step 720, forming the electrical connections between both dies. In one embodiment, the first and second dies are permanently mounted to each other. In one embodiment, the first and second dies are stacked face-to-face and the second die has a smaller face area than the face area of the first die.

The pad of the first die is coupled to the dam in step 725. In another embodiment the pad of the first die is coupled to the dam during formation. The dam may be a single ring or may be a plurality of rings or sections. The dam may be coupled to only a single side of the first die or the dam may be coupled to multiple sides of the first die. In one embodiment, the dam is coupled to the first die on every side. Further, the dam may be coupled to a side of the first die in pairs, one for power and one for ground. Additionally, multiple pairs may be provided between the dam and each side of the first die. The method ends at 735.

Although the invention is described herein with reference to specific embodiments, various modifications and changes can be made without departing from the scope of the invention as set forth in the claims below. Accordingly, the specification and figures are to be regarded in an illustrative rather than a restrictive sense, and all such modifications are intended to be included within the scope of the invention. Any benefits, advantages, or solutions to problems that are described herein with regard to specific embodiments are not intended to be construed as a critical, required, or essential feature or element of any or all the claims.

According to an example, a semiconductor apparatus for power distribution on a die is provided, which comprises a first die, a dam coupled to the first die, a second die, a pair of metal connectors coupled to the dam and the first die, and power and ground wires coupled to the dam. The first die comprises a first integrated circuit. The dam is a ring. The second die comprises a second integrated circuit. The first and second dies are stacked together and are electrically connected. The power transmitted through the power and ground wires is distributed through the dam and metal connectors to the first die and the power transmitted to the first die is distributed to the second die. According to an example, the dam is a continuous metal ring. According to an example, the dam comprises at least 2 metal rings. According to an example, the pair of metal connectors coupled to the dam comprises at least two pairs of metal conductors coupled to the dam. According to an example, the at least two pairs of metal connectors are connected at different locations on the dam. According to an example, the at least two pair of metal connectors couple to the first die with a first pair of metal conductors coupled to a first edge and a second pair of metal conductors coupled to a second edge. According to an example, at least two pair of metal connectors couple to each edge of the first die. According to an example, each of the metal connection is of the same length. According to an example, the ring comprises a low resistive material ring. According to an example, the low resistive material is comprised of copper. According to an example, the semiconductor apparatus further comprises copper pillars formed on the first die and receiving cavities formed on the second die. The receiving cavities are coupled to the copper pillars when the first die and second die are stacked together. According to an example, the stacked first and second die are permanently connected.

According to an example, a method for forming a multiple die semiconductor apparatus is provided, accord to which a dam is formed on a first die, a second die is stacked with the first die, and a pair of metal connectors is coupled to the dam and an edge of the first die. According to an example, the step of forming a dam comprises forming a metal dam. According to an example, the step of forming a metal dam comprises forming a low resistive metal dam. According to an example, the step of coupling a pair of metal connectors to the dam and an edge of the first die comprises coupling a pair of metal connectors to the dam and each edge of the first die. According to an example, the step of coupling a pair of metal connectors to the dam and an edge of the first die comprises coupling at least two pair of metal connectors to the dam and an edge of the first die. According to an example, the step of coupling at least two pair of metal connectors to the dam and an edge of the first die comprises coupling at least two pair of metal connectors to the dam and each side of the first die. According to an example, the step of coupling the dam to the pads of the first die. According to an example, the step of forming a dam comprises forming at least two metal rings.

From time-to-time, the invention is described herein in terms of these example embodiments. Description in terms of these embodiments is provided to allow the various features and embodiments of the invention to be portrayed in the context of an exemplary application. After reading this description, it will become apparent to one of ordinary skill in the art how the invention can be implemented in different and alternative environments. Unless defined otherwise, all technical and scientific terms used herein have the same meaning as is commonly understood by one of ordinary skill in the art to which this invention belongs.

The preceding discussion is presented to enable a person skilled in the art to make and use the invention. The general principles described herein may be applied to embodiments and applications other than those detailed below without departing from the spirit and scope of the invention as defined by the appended claims. The invention is not intended to be limited to the embodiments shown, but is to be accorded the widest scope consistent with the principles and features disclosed herein.

In addition, while a particular feature of the invention may have been disclosed with respect to only one of several embodiments, such feature may be combined with one or more other features of the other embodiments as may be desired. It is therefore, contemplated that the claims will cover any such modifications or embodiments that fall within the true scope of the invention.

The various diagrams may depict an example architectural or other configuration for the invention, which is done to aid in understanding the features and functionality that can be included in the invention. The invention is not restricted to the illustrated example architectures or configurations, but the desired features can be implemented using a variety of alternative architectures and configurations. Indeed, it will be apparent to one of skill in the art how alternative functional, logical or physical partitioning and configurations can be implemented to implement the desired features of the invention. Also, a multitude of different constituent module names other than those depicted herein can be applied to the various partitions. Additionally, with regard to flow diagrams, operational descriptions and method claims, the order in which the steps are presented herein shall not mandate that various embodiments be implemented to perform the recited functionality in the same order unless the context dictates otherwise.

Terms and phrases used in this document, and variations thereof, unless otherwise expressly stated, should be construed as open ended as opposed to limiting. As examples of the foregoing: the term "including" should be read as meaning "including, without limitation" or the like; the term "example" is used to provide exemplary instances of the item in discussion, not an exhaustive or limiting list thereof; the terms "a" or "an" should be read as meaning "at least one", "one or more" or the like; and adjectives such as "conventional", "traditional", "normal", "standard", "known" and terms of similar meaning should not be construed as limiting the item described to a given time period or to an item available as of a given time, but instead should be read to encompass conventional, traditional, normal, or standard technologies that may be available or known now or at any time in the future. Likewise, where this document refers to technologies that would be apparent or known to one of ordinary skill in the art, such technologies encompass those apparent or known to the skilled artisan now or at any time in the future.

A group of items linked with the conjunction "and" should not be read as requiring that each and every one of those items be present in the grouping, but rather should be read as "and/or" unless expressly stated otherwise. Similarly, a group of items linked with the conjunction "or" should not be read as requiring mutual exclusivity among that group, but rather should also be read as "and/or" unless expressly stated otherwise. Furthermore, although items, elements or components of the invention may be described or claimed in the singular, the plural is contemplated to be within the scope thereof unless limitation to the singular is explicitly stated.

The presence of broadening words and phrases such as "one or more", "at least", "but not limited to" or other like phrases in some instances shall not be read to mean that the narrower case is intended or required in instances where such broadening phrases may be absent. The use of the term "module" does not imply that the components or functionality described or claimed as part of the module are all configured in a common package. Indeed, any or all of the various components of a module, whether control logic or other components, can be combined in a single package or separately maintained and can further be distributed across multiple locations.

Unless stated otherwise, terms such as "first" and "second" are used to arbitrarily distinguish between the elements such terms describe. Thus, these terms are not necessarily intended to indicate temporal or other prioritization of such elements.

Additionally, the various embodiments set forth herein are described in terms of exemplary block diagrams, flow charts and other illustrations. As will become apparent to one of ordinary skill in the art after reading this document, the illustrated embodiments and their various alternatives can be implemented without confinement to the illustrated examples. For example, block diagrams and their accompanying description should not be construed as mandating a particular architecture or configuration.

## Claims

1. A semiconductor apparatus for power distribution on a die, the semiconductor apparatus, comprising:
a first die (200, 405, 620), wherein the first die comprises a first integrated circuit;
a dam (204, 625) coupled to the first die, wherein the dam is a ring;
a second die (305, 410, 615), wherein the second die comprises a second integrated circuit;
wherein the first and second dies are stacked together and are electrically connected;
a pair of metal connectors coupled to the dam and the first die;
power and ground wires (330, 435, 440, 605, 610) coupled to the dam, wherein the power transmitted through the power and ground wires is distributed through the dam and metal connectors to the first die and wherein the power transmitted to the first die is distributed to the second die.

2. The semiconductor apparatus of claim 1, wherein the dam is a continuous metal ring.

3. The semiconductor apparatus of claim 1 or claim 2, wherein the pair of metal connectors coupled to the dam comprises at least two pairs of metal conductors coupled to the dam.

4. The semiconductor apparatus of claim 3, wherein the at least two pairs of metal connectors are connected at different locations on the dam.

5. The semiconductor apparatus of claim 3 or claim 4, wherein the at least two pair of metal connectors couple to the first die with a first pair of metal conductors coupled to a first edge and a second pair of metal conductors coupled to a second edge.

6. The semiconductor apparatus of claim 5, wherein at least two pair of metal connectors couple to each edge of the first die.

7. The semiconductor apparatus of claim 6, wherein each of the metal connection is of the same length.

8. The semiconductor apparatus of any one of the claims 1 to 7 further comprising copper pillars (350, 370, 425, 430, 435) formed on the first die and receiving cavities formed on the second die, the receiving cavities coupled to the copper pillars when the first die and second die are stacked together.

9. A method for forming a multiple die semiconductor apparatus, the method comprising the steps of:
forming (710) a dam (204, 625) on a first die (200, 405, 620);
stacking (720) a second die (305, 410, 615) with the first die; and
coupling (725) a pair of metal connectors to the dam and an edge of the first die.

10. The method of claim 9, wherein the step of forming a dam comprises forming a metal dam.

11. The method of claim 9 or claim 10, wherein the step of coupling a pair of metal connectors to the dam and an edge of the first die comprises coupling a pair of metal connectors to the dam and each edge of the first die.

12. The method of any one of the claims 9 to 11, wherein the step of coupling a pair of metal connectors to the dam and an edge of the first die comprises coupling at least two pair of metal connectors to the dam and an edge of the first die.

13. The method of claim 12, wherein the step of coupling at least two pair of metal connectors to the dam and an edge of the first die comprises coupling at least two pair of metal connectors to the dam and each side of the first die.

14. The method of any one of the claims 9 to 13 further comprising the step of coupling the dam to the pads of the first die.

15. The method of any one of the claims 9 to 14, wherein the step of forming a dam comprises forming at least two metal rings.
